# EUROPEAN PATENT APPLICATION

(11) **EP 4 715 870 A1**
(43) Date of publication of application: **25.03.2026**
(21) Application number: 24201260.7
(22) Date of filing: 19.09.2024
(51) Int. Cl.: H01L 23/00, H01L 23/495

(54) **TRANSISTOR CHIP PACKAGE WITH BENT CLIP**

(71) Applicant: Infineon Technologies Austria AG, 9500 Villach (AT)
(72) Inventor: MAT, Fitri Rafzanjani, 71450 Seremban, Bandar Seremban Selatan (MY); TEOH, Joo Teng, 76450 Melaka (MY); CHEE, Guey Yong, 75350 Batu Berendam (MY); HONG, Chii Shang, 75450 Bukit Katil, Taman Bukit Katil Damai (MY)
(74) Representative: Lambsdorff & Lange Patentanwälte Partnerschaft mbB

(57) **Abstract**

A transistor package comprises a transistor chip having a first main side and a second main side opposite the first main side. The transistor chip comprises a first load electrode and a second load electrode on the first main side. The transistor package comprises a carrier facing the second main side of the transistor chip, a first terminal post arranged laterally beside the transistor chip and a second terminal post arranged laterally beside the transistor chip on an opposite side. A first clip connects the first load electrode to the first terminal post. A second clip connects the second load electrode to the second terminal post. At least one of the first clip and the second clip includes a first contact element which projects from a first side wall of the at least one of the first clip and the second clip and is bent downwards in a direction towards the transistor chip to electrically contact the first load electrode or the second load electrode of the transistor chip, a bending axis being in a longitudinal direction of the at least one of the first clip and the second clip.

## Description

### Technical Field

This disclosure relates generally to the technique of semiconductor packaging, and in particular to a transistor chip package using clips for an internal package interconnect.

### Background

Transistor packages are widely used as electronic switches in a variety of electronic circuits. Higher efficiency, increased power density, lower switching losses, faster switching times, lower device resistances and device parasitics and lower cost are among the key goals for next generation transistor package design.

Conventional approaches to reduce device resistances and device parasitics and to improve thermal behavior are to use clips for connecting the load electrodes of a semiconductor transistor chip to the respective terminals of the transistor package. Clip attachment, which is typically carried out by clip attachment machines, significantly contributes to the overall packaging cost.

### Summary

According to an aspect of the disclosure, a transistor package comprises a transistor chip having a first main side and a second main side opposite the first main side. The transistor chip comprises a first load electrode and a second load electrode on the first main side. The transistor package comprises a carrier facing the second main side of the transistor chip, a first terminal post arranged laterally beside the transistor chip and a second terminal post arranged laterally beside the transistor chip on an opposite side. A first clip connects the first load electrode to the first terminal post. A second clip connects the second load electrode to the second terminal post. At least one of the first clip and the second clip includes a first contact element which projects from a first side wall of the at least one of the first clip and the second clip and is bent downwards in a direction towards the transistor chip to electrically contact the first load electrode or the second load electrode of the transistor chip, a bending axis being in a longitudinal direction of the at least one of the first clip and the second clip.

According to another aspect of the disclosure, a method of manufacturing the transistor package as set out above comprises placing the transistor chip on the carrier. The first terminal post is provided and the second terminal post is provided. The first contact element is bent downwards so that a bending section of the first contact element is formed. The first clip is placed to connect between the first load electrode and the first terminal post. The second clip is placed to connect between the second load electrode and the second terminal post.

### Brief description of the drawings

In the drawings, like reference numerals designate corresponding similar parts. The features of the various illustrated embodiments can be combined unless they exclude each other and/or can be selectively omitted if not described to be necessarily required. Embodiments are depicted in the drawings and are exemplarily detailed in the detailed description which follows.
Figure 1 is a side view of an example of a transistor package including a transistor chip and first and second clips of an internal interconnect.
Figure 2 is a top view of an example of a transistor package such as, e.g., shown in Figure 1.
Figure 3 is a perspective top view on a clip attach frame containing a plurality of first clips.
Figure 4 is a perspective top view on a clip attach frame containing a plurality of second clips.
Figure 5 is a side view of an example of a transistor package including a transistor chip and first and second clips of an internal interconnect according to the disclosure.
Figure 6 is a perspective top view of an example of a transistor package (e.g., the transistor package shown in Figure 5) according to the disclosure.
Figure 7 is a perspective top view on a portion of a clip attach frame containing a plurality of first clips and second clips according to the disclosure.
Figure 8 is a perspective top view of an example of a first clip according to the disclosure.
Figure 9 is a perspective top view of an example of a second clip according to the disclosure.
Figure 10 is a perspective top view of the first clip and the second clip illustrating the bending process for forming the bending sections of the contact elements of the first and second clips.
Figure 11 is a flowchart for showing exemplary stages of manufacturing a transistor package as, e.g., shown in Figures 1 to 4.
Figure 12 is a flowchart for showing exemplary stages of manufacturing a transistor package according to the disclosure.

### Detailed description

It is to be understood that the features of the various exemplary embodiments and examples described herein may be combined with each other unless specifically noted otherwise.

As used in this specification, the terms "electrically connected" or "electrically coupled" or similar terms are not meant to mean that the elements are directly contacted together; intervening elements may be provided between the "electrically connected" or "electrically coupled" elements, respectively. However, in accordance with the disclosure, the above-mentioned and similar terms may, optionally, also have the specific meaning that the elements are directly contacted together, i.e. that no intervening elements are provided between the "electrically connected" or "electrically coupled" elements, respectively.

Further, the words "over" or "beneath" with regard to a part, element or material layer formed or located or arranged "over" or "beneath" a surface may be used herein to mean that the part, element or material layer be located (e.g. placed, formed, arranged, deposited, etc.) "directly on" or "directly under", e.g. in direct contact with, the implied surface. The word "over" or "beneath" used with regard to a part, element or material layer formed or located or arranged "over" or "beneath" a surface may, however, either be used herein to mean that the part, element or material layer be located (e.g. placed, formed, arranged, deposited, etc.) "indirectly on" or "indirectly under" the implied surface, with one or more additional parts, elements or layers being arranged between the implied surface and the part, element or material layer.

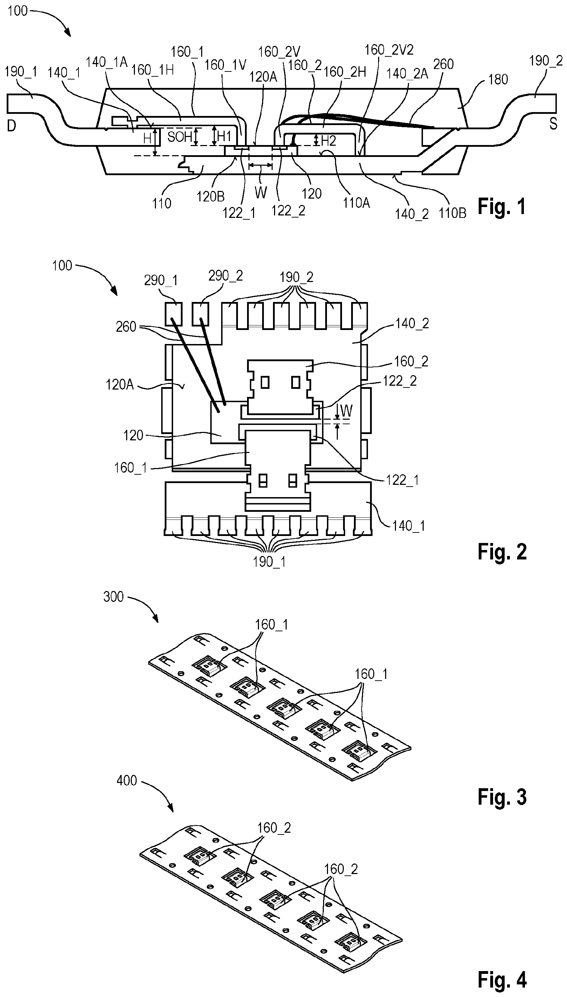

Figure 1 illustrates a side view of an example of a transistor package 100, wherein mold material of an (optional) encapsulant 180 is shown transparent for the purpose of illustration. The transistor package 100 includes a carrier 110 and a transistor chip (die) 120 mounted on the carrier 110.

The transistor chip 120 has a first main side 120A and a second main side 120B opposite the first main side 120A. The second main side 120B of the transistor chip 120 faces the carrier 110. For example, the second main side 120B of the transistor chip 120 may be attached to the carrier 110 by bonding material (not shown), e.g., a solder material, a sinter material or an electrically conducting glue.

The carrier 110 may, e.g., be a metallic carrier such as, e.g., a leadframe. In other examples, the carrier 110 may, e.g., be a PCB (printed circuit board) or a ceramic-based carrier such as, e.g., a DCB (direct copper bonding) carrier.

The transistor chip 120 includes a first load electrode 122_1 and a second load electrode 122_2. The first load electrode 122_1 and the second load electrode 122_2 are arranged on the first main side 120A of the transistor chip 120.

For example, the first load electrode 122_1 may be a drain (D) electrode of the transistor chip 120 and the second load electrode 122_2 may be a source (S) electrode of the transistor chip 120.

The transistor chip 120 may be configured as a power chip. Power chips are suitable, in particular, for switching high currents and/or medium or high voltages (e.g., more than 50 V or 100 V or 200 V or 300 V blocking voltage). In particular, exemplary transistor packages as disclosed herein may operate in the medium voltage (MV) range, in which the blocking voltage is equal to or greater than or less than 200 V or 150 V or 100 V or 50 V.

The transistor chip 120 may be of different types. Examples described herein are, in particular, directed to HEMT (high electron mobility transistor) devices. More specifically, the transistor chip 120 referred to herein may, e.g., be a III-V compound semiconductor chip having, e.g., a high band gap. The transistor chip 120 may, e.g., be a GaN chip. In this case, the GaN chip 120 may, e.g., be a lateral GaN-on-substrate device such as a GaN-on-Si device or a GaN-on-SiC device or a GaN-on-sapphire device, for example.

In general, the transistor chip 120 may, e.g., be a horizontal semiconductor device (also referred to as lateral semiconductor device) having load electrodes 122_1, 122_2 only at the first main side 120A of the transistor chip 120. In horizontal semiconductor devices, the load current is flowing mainly in a horizontal (lateral) direction between the load electrodes 122_1, 122_2.

The transistor package 100 further includes a first terminal post 140_1 arranged laterally beside the transistor chip 120 and a second terminal post 140_2 arranged laterally beside the transistor chip 120 on an opposite side of the transistor chip 120.

The transistor package 100 further includes a first clip 160_1 and a second clip 160_2. The first clip 160_1 connects the first load electrode 122_1 to the first terminal post 140_1. The second clip 160_2 connects the second load electrode 122_2 to the second terminal post 140_2. The first clip 160_1 and the second clip 160_2 may be made, e.g., of copper or aluminum or a copper-based or aluminum-based alloy, for example.

The first clip 160_1 and the second clip 160_2 are configured as load current clips. In the example shown, the first clip 160_1 is, e.g., a drain (D) clip and the second clip 160_2 is, e.g., a source (S) clip.

An upper surface 140_1A of the first terminal post 140_1 and an upper surface 140_2A of the second terminal post 140_2 may, e.g., be arranged at different levels of height measured from an upper surface 110A of the carrier 110. For example, the height of the upper surface 140_1A of the first terminal post 140_1 over the upper surface 110A of the carrier 110 is H. The height of the upper surface 140_2A of the second terminal post 140_2 over the upper surface 110A of the carrier 110 is, for example, zero (for example, if the second terminal post 140_2 is formed by an area on the upper surface 110A of the carrier 110).

In other examples, the height of the upper surface 140_2A of the second terminal post 140_2 (which does not need to be formed by an area of the carrier 110 but may also be formed similar as the first terminal post 140_1) may be greater than zero, e.g., also H, or any other value between zero and H, for example.

In the following, the distance between the upper surface 140_1A of the first terminal post 140_1 and the upper surface of the transistor chip 120 at the first main side 120A thereof is referred to as SOH (standoff height) of the first clip 160_1. In other words, SOH is the free height bridged by the first clip 160_1. Typically, in particular in cases in which a lower surface 110B of the carrier 110 remains exposed at the transistor package 100, the SOH of the first clip 160_1 may need to be rather high. For example, the SOH may, e.g., be equal to or greater than or less than 250 pm, 300 pm, 350 pm, 400 pm, 450 pm, or 500 pm. These rather large values for the SOH may, e.g., be due to a minimum height H which is required in some examples of packaging transistor chips 120.

The first load electrode 122_1 and the second load electrode 122_2 of the transistor chip 120 are laterally spaced apart by a gap of width W. Typically, W may, e.g., be equal to or less than or greater than 250 pm, 300 µm or 350 pm.

The first clip 160_1 may include a vertical clip portion 160_1V and and a horizontal clip portion 160_1H. The horizontal clip portion 160_1H may be attached to the first terminal post 140_1 (e.g., to the upper surface 140_1A thereof). The vertical clip portion 160_1V may be attached to the first load electrode 122_1.

Similarly, the second clip 160_2 may include a vertical clip portion 160_2V and a horizontal clip portion 160_2H. The vertical clip portion 160_2V of the second clip 160_2 may be attached to the second load electrode 122_2 and the horizontal clip portion 160_2H of the second clip 160_2 may, e.g., connect to second terminal post 140_2 (e.g., via another vertical clip portion 160_2V2).

The vertical clip portions 160_1V and 160_2V and (optionally) 160_2V2 are clip portions which need to be bent down during manufacturing the clips 160_1 and 160_2, respectively. The length of the bent down vertical clip portions 160_1V and 160_2V define a free height H1 and H2, respectively, of the first and second clips 160_1, 160_2 over the upper surface 120A of the transistor chip 120.

In some examples (as, e.g., for transistor package 100), H1 is equal to greater than SOH. Then, also H1 may need to be rather large because of the minimum SOH requirement experienced in many transistor packages 100.

For example, W < SOH. In this case, the vertical portion 160_1V of the first clip 160_1 is longer than the distance W between the load electrodes 122_1, 122_2. Even if W is equal to SOH or little greater than SOH, it might be impossible to meet a minimum clearance requirement during bending the first and second vertical clip portions 160_1V and 160_2V in a common clip frame which includes both the first clip 160_1 and the second clip 160_2, because there might not be enough material for forming the vertical clip portions 160_1V and 160_2V and (if there is enough material) not space enough space for bending them.

Figure 2 shows a top view of an example of a transistor package such as, e.g., transistor package 100 shown in Figures 1. For illustrative purposes, the encapsulation 180 is omitted.

For example, the first package terminal 190_1 includes a plurality of leads extending from the first terminal post 140_1. The second package terminal 190_2 may also include a plurality of leads extending from the second terminal post 140_2. As mentioned before, the second terminal post 140_2 may be, e.g., connected to or located on the carrier 110. For example, the second terminal post 140_2 may be formed by an area of the upper surface 110A of the carrier 110 on which the second clip 160_2 is placed.

The first package terminal 190_1 may extend along a majority or the entire length at one side of the transistor package 100. The second package terminal 190_2 may also extend along a majority or the entire length at the opposite side of the transistor package 100.

The transistor package 100 may further include a package terminal 290_1 and/or a package terminal 290_2. The package terminal 290_1 and/or the package terminal 290_2 may be connected, e.g., to a control electrode (e.g. gate) and/or a sense electrode on the first main side 120A of the transistor chip 120. For example, these connections may be implemented by bond wires 260.

As shown in Figure 2, the first load electrode 122_1 and/or the second load electrode 122_2 may be formed as parallel stripes extending, e.g., along the longitudinal dimension of the transistor chip 120. The distance between these stripes is the gap of width W. The stripes (i.e. the load electrodes 122_1, 122_2) may each have a width of about 0.7 mm, for example (the width of the stripes is measured in the same dimension as the width W of the distance between these stripes).

As illustrated in Figure 1, the transistor package 100 may include an encapsulant 180. For example, a molding process may be carried out to encapsulate the transistor chip 120 mounted on the carrier 110 with a mold material. The molded encapsulant 180 may, e.g., form the package body.

The carrier 110 may remain exposed at the bottom of the encapsulant 180. A heatsink (not shown) may be connected to the exposed lower surface 110B of the carrier 110. The transistor package 100 may thus be a TSC (top side cooling) package. The first and second clips 160_1, 160_2 may be completely covered by the encapsulant 180, for example.

In some examples, the transistor package 100 is a leaded package. The transistor package 100 may, e.g., include leads to form a first package terminal 190_1 and/or a second package terminal 190_2. The leads may, e.g., protrude out of a peripheral side of the encapsulant 180.

For example, the leads forming the first package terminal 190_1 (e.g. D) and/or the second package terminal 190_2 (e.g. S) may be formed as gullwing leads as shown in Figure 1.

Figure 3 and Figure 4 show conventional clip attach frames 300 and 400, respectively, used for clip attach. Clip attach frame 300 includes a plurality of first clips 160_1 arranged in a row and clip attach frame 400 includes a plurality of second clips 160_2 arranged in a row. The clip attach frame 300 is used for the process of clip attach of first clips 160_1 for a plurality of transistor packages 100, which are arranged during the clip attach process in a row, and/or the clip attach frame 400 is used for the process of clip attach of second clips 160_2 for a plurality of the transistor packages 100 arranged in a row.

Both clips 160_1, 160_2 need to be provided in separate clip attach frames 300, 400, since it is not possible to arrange the first and second clips 160_1, 160_2 in a common clip attach frame. If they would be arranged in a common clip attach frame, the geometrical constraints (in particular, large SOH and small W) of the transistor package 100 would exclude in-frame bending of the vertical clip portions 160_1V, 160_2V, since there is not enough material and/or space.

As separate clip attach frames 300, 400 are provided as shown in Figures 3 and 4, in-frame bending of the vertical clip portions 160_1V, 160_2V is easily possible since the pitch of the clips 160_1, 160_2 in each clip attach frame 400, 300 relies on the pitch of the transistor packages 100 arranged in a row during the process of manufacturing, but not on the distance W.

That is, during conventional manufacturing, one clip attach frame 300 serves to provide the first clips 160_1 for a plurality of transistor packages 100 and another clip attach frame 400 serves to provide the second clips 160_2 for the transistor package 100. The first clips 160_1 (e.g. drain clips) and the second clips 160_2 (e.g. source clips) are placed in subsequent pick-and-place operations per transistor package 100.

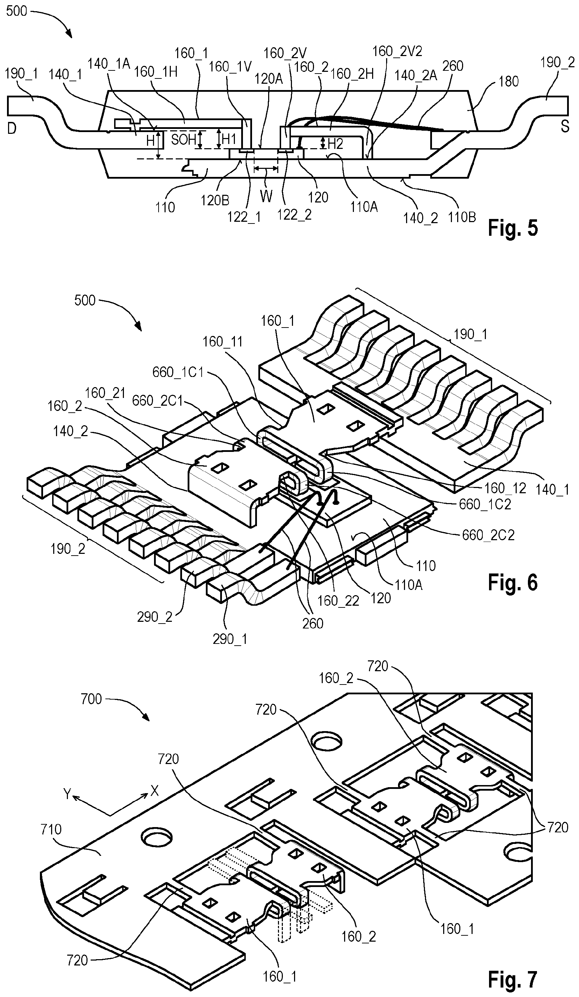

Figures 5 and 6 illustrate an example of a transistor package 500 according the disclosure. Transistor package 500 is designed in accordance with the features described for the transistor package 100 except for the differences detailed below. Therefore, to avoid reiteration, the features described for transistor package 100 are included by reference into the description of transistor package 500.

The transistor package 500 distinguishes from the transistor package 100 in that at least for one of the first clip 160_1 and the second clip 160_2, the vertical clip portion 160_1V and/or 160_2V is differently formed than in transistor package 100. More specifically, the first clip 160_1 includes a first contact element 660_1C1 which projects from a first side wall 160_11 of the first clip 160_1 and is bent downwards in a direction towards the transistor chip 120 to electrically contact the first load electrode 122_1, a bending axis being in a longitudinal direction of the first clip 160_1. Alternatively or additionally, the second clip 160_2 includes a first contact element 660_2C1 which projects from a first side wall 160_21 of the second clip 160_2 and is bent downwards in a direction towards the transistor chip 120 to electrically contact the second load electrode 122_2, a bending axis being in a longitudinal direction of the second clip 160_2.

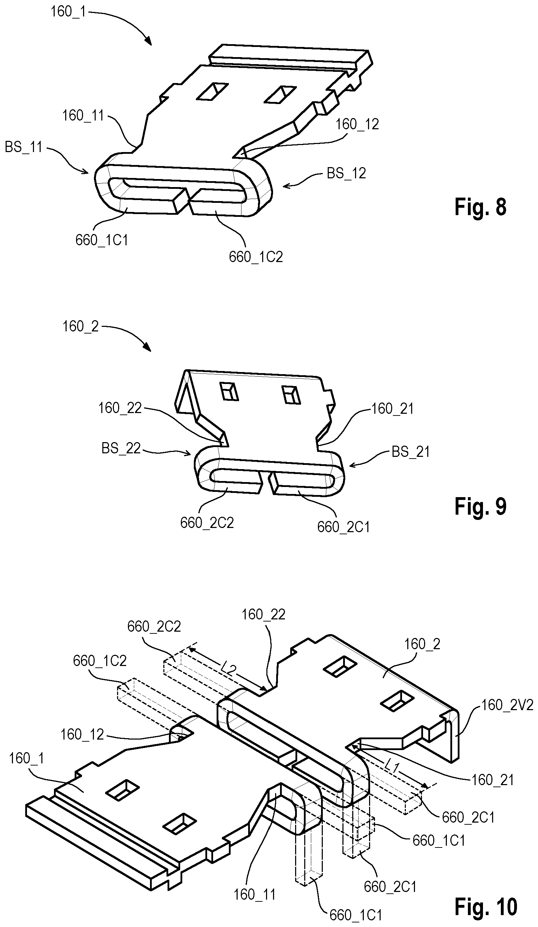

Referring to Figures 8 and 9, in some examples, a bending section BS_11 of the first contact element 660_1C1 of the first clip 160_1 may be U-shaped and/or a bending section BS_21 of the first contact element 660_2C1 of the second clip 160_2 may be U-shaped. U-shaped bending section(s) BS_11, BS_21 allow(s) to provide large contact area(s) between the first contact element(s) 660_1C1, 660_2C1 and the respective first and second load electrodes 122_1, 122_2.

Further, in some examples, the first clip 160_1 includes a second contact element 660_1C2 which projects from a second side wall 160_12 of the first clip 160_1 and is bent downwards in a direction towards the transistor chip 120 to electrically contact the first load electrode 122_1, a bending axis being in a longitudinal direction of the first clip 160_1. Alternatively or additionally, the second clip 160_2 includes a second contact element 660_2C2 which projects from a second side wall 160_22 of the second clip 160_2 and is bent downwards in a direction towards the transistor chip 120 to electrically contact the second load electrode 122_2, a bending axis being in a longitudinal direction of the second clip 160_2. First and second contact elements 660_1C1, 660_1C2 or 660_2C1, 660_2C2 at both sides of the respective clip 160_1, 160_2 facilitate the clip attach process and improve mechanical stability of the respective clip 160_1, 160_2 mounted on the transistor chip 120.

In some examples, a bending section BS_12 of the second contact element 660_1C2 of the first clip 160_1 may be U-shaped and/or a bending section BS_22 of the second contact element 660_2C2 of the second clip 160_2 may be U-shaped. U-shaped bending section(s) BS_12, BS_22 allow(s) to provide large contact area(s) between the second contact element(s) 660_1C2, 660_2C2 and the respective first and second load electrodes 122_1, 122_2.

Due to the U-shaped bending section BS_11 or BS_21 of the first contact element 600_1C1 or 600_2C1, a contact surface of the first contact element 600_1C1 or 600_2C1 which faces the transistor chip 120 is a bent portion of an upper surface of the respective clip 160_1 or 160_2 which faces away from the transistor chip 120. Analogously, a contact surface of the second contact element 600_1C2 or 600_2C2 which faces the transistor chip 120 is a bent portion of an upper surface of the respective clip 160_1, 160_2 which faces away from the transistor chip 120. The U-shaped bending sections BS_11, BS_12, BS_21 or BS_22 may each be bent by more than 90° and, in particular, by about 180°, for example.

The U-shaped bending sections BS_11, BS_12, BS_21 or BS_22 make it possible to form the vertical clip portion 160_1V and/or 160_2V (Figure 5) without sharp cutting edges that could come into contact with the sensitive surfaces of the first and second load electrodes 122_1, 122_2. Therefore, there is less risk of damage to the transistor chip 120 during the process of clip placement. In contrast, if the vertical clip portions 160_1V, 160_2V are formed by bending around a transverse axis of the respective clip 160_1, 160_2 (see Figure 1), sharp cutting edges at the ends of the respective vertical clip portions 160_1V, 160_2V may damage the respective load electrode 122_1, 122_2.

Further, it has been verified by simulations that longitudinal-axis bending of contact elements 660_1C1, 660_1C2, 660_2C1, 660_2C2 as disclosed herein (e.g., Figure 6) provides electrical package resistances which are comparable with the electrical package resistances obtained with transverse-axis bending (e.g., Figure 1) of the clips 160_1, 160_2. These package resistances are significantly lower than any package resistances which can be obtained by using bond wires instead of clips.

Figure 7 illustrates an example of a clip attach frame 700 according to the disclosure. The first clip 160_1 and the second clip 160_2 are implemented in the same clip attach frame 700. More specifically, the clip attach frame 700 includes a frame 710 and first clips 160_1 and second clips 160_2 connected to the frame 710 by bars 720. Pairs of a first clip 160_1 and a second clip 160_2 are arranged in a row. Figure 7 illustrates a portion of a clip attach reel which is used in a clip attach machine for the process of clip attachment to a row of transistor packages 500.

Figures 7 and 10 illustrate the process of in-frame bending of the first contact element(s) 660_1C1, 660_2C1 and/or the second contact element(s) 660_1C2, 660_2C2. As the bending axis is always in the longitudinal direction X of the first clip 160_1 or the second clip 160_2 rather than in the transverse direction Y, the bending process(es) carried out at the first clip 160_1 do not interfere with the position of the second clip 160_2 and vice versa. Therefore, both clips 160_1, 160_2 can be integrated on one and the same clip attach frame 700, see Figure 7.

In other words, in contrast to the situation when using a bending axis in transverse direction (see, e.g., clip attach frames 300, 400), there is always enough space and material to complete both clips 160_1, 160_2 in the same clip attach frame 700. This is due to the fact that the dimensional limitation exists in the longitudinal direction, while the bending is relocated according to the disclosure in the transverse direction.

Further, if contact elements 660_1C1, 660_1C2 at both side walls 160_11, 160_12 of the first clip 160_1 are bent and/or if contact elements 660_2C1, 660_2C2 at both side walls 160_21, 160_22 of the second clip 160_2 are bent, the corresponding bending axes may, e.g., be parallel and spaced apart from each other.

Figure 10 illustrate that a first contact element (here, for example, the first contact element 660_2C1 of the second clip 160_2 is used for illustration) may have a length L1 and a second contact element (e.g., 660_2C2 as shown or 660_1C2) may have a length L2. For example, as there is enough space in the transverse direction for bending, L1 > W and/or L2 > W may be chosen.

Only one clip attachment process is required to attach the first clip 160_1 and the second clip 160_2 together on the transistor chip 120 of each transistor package 500. Thus, cost reduction is achieved by the measure of needing only one clip attachment process for attaching simultaneously the first clip 160_1 and second clip 160_2. Further, only a single clip attach reel (clip attach frame 700) is needed for providing the first clip 160_1 and the second clip 160_2 for one or a plurality of transistor packages 500.

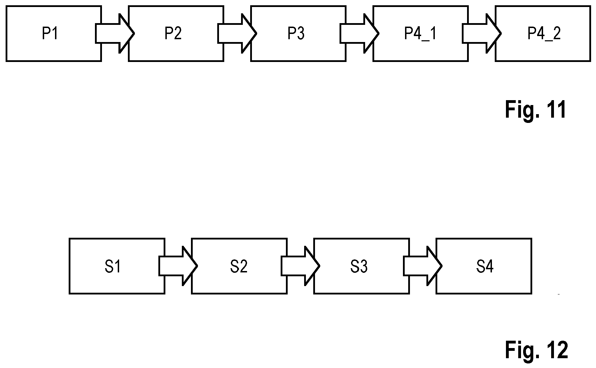

Referring to Figure 11, a method of manufacturing a transistor package 100 may include, at P1, depositing a bonding material on the carrier. For example, depositing the bonding material may be carried out by screen printing. At that time, the first terminal post 140_1 and the second terminal post 140_2 may, e.g., already be provided.

At P2, the transistor chip 120 is placed on the carrier 110 (so-called "die attach").

At P3, a bonding material (e.g., solder, sinter material, conducting glue, etc.) may be dispensed on the load electrodes 122_1, 122_2 at the top of the transistor chip 120.

At P4_1, the first clip 160_1 is attached to the transistor chip 120. More specifically, at P4_1, the first clip 160_1 is placed to connect between the first load electrode 122_1 and the first terminal post 140_1. This may be carried out by using the clip attach frame 300 (see Figure 3) which includes a plurality of first clips 160_1 arranged in a row. Before the clip attach at P4_1, the first clips 160_1 have been bent in the clip attach frame 300 to produce the vertical clip portion 160_1V.

Subsequently, at P4_2, the second clip 160_2 is attached to the transistor chip 120. More specifically, at P4_2, the second clip 160_2 is placed to connect between the second load electrode 122_2 and the second terminal post 140_2. This may be carried out by using the clip attach frame 400 (see Figure 4) which includes a plurality of second clips 160_2 arranged in a row. Before the clip attach at P4_2, the second clips 160_2 have been bent in the clip attach frame 400 to produce the vertical clip portion 160_2V and (optionally) the vertical clip portion 160_2V2.

In other words, a two-stage clip attach process P4_1, P4_2 is conventionally required. For example, the placement of the first clip 160_1 (at P4_1) and the placement of the second clip 160_2 (at P4_2) are carried out one after the other.

Referring to Figure 12, a method of manufacturing a transistor package 500 may include, at S1, depositing a bonding material on the carrier 110. For example, depositing the bonding material may be carried out by screen printing. At that time, the first terminal post 140_1 and the second terminal post 140_2 may, e.g., already be provided.

At S2, the transistor chip is placed on the carrier 110 (so-called "die attach").

At S3, a bonding material (e.g., solder, sinter material, conducting glue, etc.) may be dispensed on the load electrodes 122_1, 122_2 at the top of the transistor chip 120.

At S4, the first clip 160_1 and the second clip 160_2 are attached to the transistor chip 120. More specifically, at S4, the first clip 160_1 is placed to connect between the first load electrode 122_1 and the first terminal post 140_1 and the second clip 160_2 is placed to connect between the second load electrode 122_2 and the second terminal post 140_2. This may be carried out by using the clip attach frame 700 (see Figure 7), which includes a plurality of pairs of first clips 160_1 and second clips 160_2 arranged in a row. Before the clip attach at S4, the contact elements 660_1C1, 660_1C2 and/or 660_2C1, 660_2C2 of the first clips 160_1 and/or the second clips 160_2 have been bent in the clip attach frame 700 to produce the bending sections BS_11, BS_12, BS_21, BS_22 and thus the vertical clip portions 160_1V and/or 160_2V of the respective clips (see Figure 5).

In other words, a single-stage clip attach process S4 is possible for clip attachment of the first clip 160_1 and the second clip 160_2. Placing the first clip 160_1 and placing the second clip 160_2 may be carried out together. Both clips 160_1, 160_2 may be implemented in the same clip reel and may be picked up at the same time for clip placement at S4.

### EXAMPLES

The following examples pertain to further aspects of the disclosure:
Example 1 is a transistor package comprising a transistor chip having a first main side and a second main side opposite the first main side. The transistor chip comprises a first load electrode and a second load electrode on the first main side. The transistor package comprises a carrier facing the second main side of the transistor chip, a first terminal post arranged laterally beside the transistor chip and a second terminal post arranged laterally beside the transistor chip on an opposite side. At least one of the first clip and the second clip includes a first contact element which projects from a first side wall of the at least one of the first clip and the second clip and is bent downwards in a direction towards the transistor chip to electrically contact the first load electrode or the second load electrode of the transistor chip, a bending axis being in a longitudinal direction of the at least one of the first clip and the second clip.
In Example 2, the subject matter of Example 1 can optionally include wherein a bending section of the first contact element is U-shaped.
In Example 3, the subject matter of Example 1 or 2 can optionally include wherein the at least one of the first clip and the second clip comprises a second contact element which projects from a second side wall of the at least one of the first clip and the second clip and is bent downwards in a direction towards the transistor chip to electrically contact the first load electrode or the second load electrode, wherein the second side wall is arranged opposite the first side wall.
In Example 4, the subject matter of Example 3 can optionally include wherein a bending section of the second contact element is U-shaped.
In Example 5, the subject matter of any Examples 3 or 4 can optionally include wherein the first contact element projects in a first direction from the first side wall, the second contact element projects in a second direction from the second side wall, and the first direction and the second direction are opposite.
In Example 6, the subject matter of any of the preceding Examples can optionally include wherein a contact surface of the first contact element faces the transistor chip and is a bent portion of an upper surface of the respective clip which faces away from the transistor chip.
In Example 7, the subject matter of any of Examples 3 to 6 can optionally include wherein a contact surface of the second contact element faces the transistor chip and is a bent portion of an upper surface of the respective clip which faces away from the transistor chip.
In Example 8, the subject matter of any of the preceding Examples can optionally include wherein the first load electrode and the second load electrode are laterally spaced apart by a gap of width W, a length of the first contact element is L, and W < L.
In Example 9, the subject matter of any of the preceding Examples can optionally include wherein the first load electrode and the second load electrode are laterally spaced apart by a gap of width W, a free height of the first clip and/or the second clip is SOH, and W < SOH.
In Example 10, the subject matter of any of the preceding Examples can optionally include wherein the carrier is a leadframe.
In Example 11, the subject matter of any of the preceding Examples can optionally include wherein the package is a leaded package and the first terminal post is a lead posts.
Example 12 is a method of manufacturing the transistor package of any of the preceding Examples. The method comprises placing the transistor chip on the carrier; providing the first terminal post and providing the second terminal post; bending the first contact element downwards, so that a bending section of the first contact element is formed; placing the first clip to connect between the first load electrode and the first terminal post; and placing the second clip to connect between the second load electrode and the second terminal post.
In Example 13, the subject matter of Example 12 can optionally include wherein the first clip and the second clip are integral parts of a common clip frame when bending the at least first contact element downwards is carried out.
In Example 14, the subject matter of Example 13 or 13 can optionally include wherein the first clip and the second clip are integral parts of a common clip frame when placing the first clip and placing the second clip is carried out.
In Example 15, the subject matter of any of the Examples 12 to 14 can optionally include wherein the bending section is U-shaped.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A transistor package comprising:
a transistor chip having a first main side and a second main side opposite the first main side, the transistor chip comprises a first load electrode and a second load electrode on the first main side;
a carrier facing the second main side of the transistor chip,
a first terminal post arranged laterally beside the transistor chip;
a second terminal post arranged laterally beside the transistor chip on an opposite side of the transistor chip;
a first clip connecting the first load electrode to the first terminal post;
a second clip connecting the second load electrode to the second terminal post; wherein
at least one of the first clip and the second clip includes a first contact element which projects from a first side wall of the at least one of the first clip and the second clip and is bent downwards in a direction towards the transistor chip to electrically contact the first load electrode or the second load electrode of the transistor chip, a bending axis being in a longitudinal direction of the at least one of the first clip and the second clip.

2. The transistor package of claim 1, wherein a bending section of the first contact element is U-shaped.

3. The transistor package of claim 1 or 2, wherein the at least one of the first clip and the second clip comprises a second contact element which projects from a second side wall of the at least one of the first clip and the second clip and is bent downwards in a direction towards the transistor chip to electrically contact the first load electrode or the second load electrode of the transistor chip, wherein the second side wall is arranged opposite the first side wall.

4. The transistor package of claim 3, wherein a bending section of the second contact element is U-shaped.

5. The transistor package of claim 3 or 4, wherein the first contact element projects in a first direction from the first side wall, the second contact element projects in a second direction from the second side wall, and the first direction and the second direction are opposite.

6. The transistor package of any of the preceding claims, wherein a contact surface of the first contact element faces the transistor chip and is a bent portion of an upper surface of the respective clip which faces away from the transistor chip.

7. The transistor package of any of claims 3 to 6, wherein a contact surface of the second contact element faces the transistor chip and is a bent portion of an upper surface of the respective clip which faces away from the transistor chip.

8. The transistor package of any of the preceding claims, wherein the first load electrode and the second load electrode are laterally spaced apart by a gap of width W, a length of the first contact element is L, and W < L.

9. The transistor package of any of the preceding claims, wherein the first load electrode and the second load electrode are laterally spaced apart by a gap of width W, a free height of the at least one of the first clip and the second clip is SOH, and W < SOH.

10. The transistor package of any of the preceding claims, wherein the carrier is a leadframe.

11. The transistor package of any of the preceding claims, wherein the package is a leaded package and the first terminal post is a lead post.

12. A method of manufacturing the transistor package of any of the preceding claims, the method comprising:
placing the transistor chip on the carrier;
providing the first terminal post and providing the second terminal post;
bending the first contact element downwards, so that a bending section of the first contact element is formed;
placing the first clip to connect between the first load electrode and the first terminal post; and
placing the second clip to connect between the second load electrode and the second terminal post.

13. The method of claim 12, wherein the first clip and the second clip are integral parts of a common clip frame when bending the first contact element downwards is carried out.

14. The method of claim 12 or 13, wherein the first clip and the second clip are integral parts of a common clip frame when placing the first clip and placing the second clip is carried out.

15. The method of any of claims 12 to 14, wherein the bending section is U-shaped.
